# EUROPEAN PATENT APPLICATION

(11) **EP 4 773 755 A1**
(43) Date of publication of application: **08.07.2026**
(21) Application number: 23953822.6
(22) Date of filing: 28.09.2023
(51) Int. Cl.: H10D 84/85

(54) **INTEGRATED CIRCUIT AND MANUFACTURING METHOD THEREFOR, AND ELECTRONIC DEVICE**

(71) Applicant: HUAWEI TECHNOLOGIES CO., LTD., Shenzhen 518129 (CN)
(72) Inventor: WU, Eric, Shenzhen, Guangdong 518129 (CN); ZHU, Jifeng, Shenzhen, Guangdong 518129 (CN)
(74) Representative: Grünecker Patent- und Rechtsanwälte PartG mbB
(86) International application number: PCT/CN2023/122990
(87) International publication number: WO 2025/065678

(57) **Abstract**

Embodiments of this application disclose an integrated circuit and a preparation method therefor, and an electronic device, and relate to the field of semiconductor technologies. The integrated circuit includes a substrate, a fin, a gate line, a source, a drain, an isolation layer, a power contact structure, and a power distribution network. The substrate has a first surface and a second surface. The fin is located on the first surface. The gate line is disposed across the fin. The isolation layer is located between two adjacent fins, and divides the gate line into a plurality of gate sub-lines. The power contact structure penetrates the substrate. The power contact structure includes a first power contact portion and a second power contact portion. The power distribution network is located on the second surface. The power distribution network is electrically connected to the first power contact portion. The second power contact portion is electrically connected to the source or the drain. The isolation layer is located on two opposite sides of the second power contact portion in a second direction. The power contact structure is split into the first power contact portion and the second power contact portion, and the isolation layer is disposed. This helps reduce process difficulty of the integrated circuit and improve reliability of the integrated circuit.

## Description

### TECHNICAL FIELD

This application relates to the field of semiconductor technologies, and in particular, to an integrated circuit and a preparation method therefor, and an electronic device.

### BACKGROUND

With continuous miniaturization of semiconductor components, density of transistors in a chip is increasingly high, and metal interconnects face increasingly high miniaturization pressure. In a backside power delivery network (backside power delivery network, BSPDN) technology, routing for supplying power by a power supply (for example, including components such as the power supply and ground) is moved from a front side of the chip to a back side of the chip, so that a chip area miniaturization benefit can be achieved, and a resistive voltage drop (IR drop) can be improved, thereby improving chip performance and reducing power consumption.

To optimize a power supply capability of the power supply, currently, a solution of moving a power rail to a substrate to form a buried power rail (buried power rail, BPR) is proposed. In this solution, a power contact (power contact/power trench) structure is disposed, and is configured to connect the transistor in the chip to a backside power delivery network.

A forming process required by the power contact structure is very difficult. In addition, disposition of a structure, for example, the buried power rail, reduces a spacing between the power contact structure and an existing structure (for example, a gate line or a fin) in the chip, and this further increases process difficulty of the power contact structure, and also brings a reliability risk.

### SUMMARY

Embodiments of this application provide an integrated circuit and a preparation method therefor, and an electronic device, to reduce process difficulty of the integrated circuit and improve reliability of the integrated circuit.

To achieve the foregoing objectives, the following technical solutions are used in embodiments of this application.

According to a first aspect, an integrated circuit is provided. The integrated circuit includes a substrate, a plurality of fins, a gate line, a source, a drain, an isolation layer, a power contact structure, and a power distribution network. The substrate has a first surface and a second surface that face away from each other. The plurality of fins are located on the first surface. The plurality of fins extend in a first direction and are spaced apart in a second direction. Both the first direction and the second direction are parallel to the first surface, and the first direction intersects with the second direction. The gate line is disposed across the plurality of fins. The gate line extends in the second direction. The isolation layer is located between two adjacent fins. The isolation layer divides the gate line into a plurality of gate sub-lines. The source and the drain are located on the fin, and one of the source and the drain is a target electrode. The power contact structure penetrates the substrate. In a direction from the second surface to the first surface, the power contact structure includes a first power contact portion and a second power contact portion located on the first power contact portion. The first power contact portion is connected to the second power contact portion. The second power contact portion is electrically connected to the target electrode. The power distribution network is located on the second surface. The power distribution network is electrically connected to the first power contact portion. The isolation layer is located on two opposite sides of the second power contact portion in the second direction.

According to the integrated circuit provided in some embodiments of this application, the power contact structure is disposed as the first power contact portion and the second power contact portion that are connected to each other, so that the first power contact portion and the second power contact portion can be prepared independently of each other, and therefore, a trench configured to accommodate the power contact structure is formed in two steps. In one step, a trench configured to accommodate the first power contact portion may be formed, and in the other step, a trench configured to accommodate the second power contact portion may be formed. Because both an aspect ratio of the first power contact portion and an aspect ratio of the second power contact portion are small, in comparison with a power contact structure that penetrates a substrate and that is prepared and formed in one step, difficulty of an etching process and a metal filling process that are required for preparing the first power contact portion is low, and difficulty of an etching process and a metal filling process that are required for preparing the second power contact portion is low. In this way, process difficulty of forming the power contact structure in this embodiment of this application can be reduced.

In addition, in this embodiment of this application, the isolation layer is disposed, so that a precision requirement of a process, for example, alignment, photolithography, or etching, required for forming, between the two adjacent fins, the second power contact portion for accommodation can be reduced, to further reduce difficulty of the process, for example, alignment, photolithography, or etching. In addition, a self-alignment function can be provided for formation of the second power contact portion by using the isolation layer, so that, in a process of forming the second power contact portion through filling, a material of the second power contact portion can be naturally filled in a region defined by the isolation layer, to avoid damage to the fin or the gate line, and improve reliability and a yield of the integrated circuit.

In a possible implementation of the first aspect, a connection surface between the first power contact portion and the second power contact portion is located within the first surface. This facilitates formation of the trench configured to accommodate the first power contact portion.

In a possible implementation of the first aspect, a surface on a side that is of the first power contact portion and that is close to the second power contact portion is a third surface, and a surface on a side that is of the second power contact portion and that is close to the first power contact portion is a fourth surface. An orthogonal projection of the fourth surface on the first surface is located within a range of an orthogonal projection of the third surface on the first surface. In this way, there can be a large contact area between the first power contact portion and the second power contact portion. In addition, difficulty of aligning the first power contact portion and the second power contact portion can be further reduced, and a yield of connection between the first power contact portion and the second power contact portion can be improved.

In a possible implementation of the first aspect, the integrated circuit further includes a gate cut structure spaced apart from the isolation layer. The gate cut structure is located between two adjacent gate sub-lines, and is located between two adjacent fins. The gate cut structure and the isolation layer are made of a same material, and are disposed on a same layer. In this embodiment of this application, a preparation process of the isolation layer is integrated with a preparation process of the gate cut structure, so that a plurality of structures such as the gate cut structure and the isolation layer can be synchronously formed in a single patterning process, and this helps simplify a preparation process of the integrated circuit.

In a possible implementation of the first aspect, in a direction perpendicular to the first surface, a height of the isolation layer is greater than a thickness of the gate cut structure. In this way, in a process of forming, through deposition, a thin film on which the isolation layer and the gate cut structure are located, it can be ensured that the thin film fully fills a trench configured to accommodate the gate cut structure, and it can also be ensured that the thin film fills only a part of the trench configured to accommodate the second power contact portion, to reserve space for the second power contact portion.

In a possible implementation of the first aspect, the integrated circuit further includes an epitaxial contact structure. The epitaxial contact structure is located on the second power contact portion and the target electrode, and is in contact with the second power contact portion and the target electrode. The epitaxial contact structure may be used as a bridge structure between the second power contact portion and the target electrode, to reduce difficulty of electrical connection between the second power contact portion and the target electrode.

In a possible implementation of the first aspect, the integrated circuit further includes a first dielectric layer. The first dielectric layer is located between the second surface and the power distribution network, and is located between the first power contact portion and the substrate. A surface on a side that is of the first power contact portion and that is away from the second power contact portion is flush with a surface on a side that is of the first dielectric layer and that is away from the second surface. The first dielectric layer may implement electrical insulation between the first power contact portion and the substrate, and implement electrical insulation between the power distribution network and the substrate.

According to a second aspect, a preparation method for an integrated circuit is provided. The preparation method includes: forming an initial integrated circuit, where the initial integrated circuit includes a substrate, a plurality of fins, a second dielectric layer, and a sacrificial layer; the substrate has a first surface and a second surface that face away from each other; the plurality of fins are located on the first surface, extend in a first direction, and are spaced apart in a second direction; the second dielectric layer is filled between two adjacent fins and covers the fins; the sacrificial layer is located on the second dielectric layer, the sacrificial layer includes a sacrificial gate disposed across the plurality of fins, and the sacrificial gate extends in the second direction; and both the first direction and the second direction are parallel to the first surface, and the first direction intersects with the second direction; forming a first gate cut trench on the sacrificial layer, where the first gate cut trench is located between two adjacent fins, and breaks the sacrificial gate; forming an isolation layer, where the isolation layer covers at least a side wall of the first gate cut trench; forming a second power contact portion in the first gate cut trench; forming a first power contact portion on a side that is of the second power contact portion and that is close to the second surface, where the first power contact portion is connected to the second power contact portion; and forming a power distribution network on the second surface, where the power distribution network is electrically connected to the first power contact portion.

In a possible implementation of the second aspect, in a process of forming the first gate cut trench on the sacrificial layer, a second gate cut trench is further formed, the second gate cut trench is located between two adjacent fins, and breaks the sacrificial gate, and in a direction perpendicular to the first surface, a depth of the second gate cut trench is less than a depth of the first gate cut trench. In a process of forming the isolation layer, a gate cut structure is further formed, and the gate cut structure is located in the second gate cut trench.

In a possible implementation of the second aspect, forming the first power contact portion on the side that is of the second power contact portion and that is close to the second surface includes: etching the substrate from a side on which the second surface is located to form a contact trench, where the contact trench exposes a surface on the side that is of the second power contact portion and that is close to the second surface; and forming the first power contact portion in the contact trench.

In a possible implementation of the second aspect, the isolation layer further covers a bottom wall of the first gate cut trench. Before forming the first power contact portion in the contact trench, the preparation method further includes: removing, through the contact trench, a part that is of the isolation layer and that covers the bottom wall of the first gate cut trench, to expose the surface on the side that is of the second power contact portion and that is close to the second surface.

In a possible implementation of the second aspect, before forming the power distribution network on the second surface, the preparation method further includes: removing the sacrificial gate to form a gate line trench; and filling the gate line trench with a conductive material to form a gate line.

According to a third aspect, an electronic device is provided. The electronic device includes a circuit board and the integrated circuit according to any implementation of the first aspect. The integrated circuit is connected to the circuit board.

For technical effects brought by any design manner in the second aspect and the third aspect, refer to technical effects brought by different design manners in the first aspect. Details are not described herein again.

### BRIEF DESCRIPTION OF DRAWINGS

FIG. 1 is a diagram of a structure of an electronic device according to an embodiment of this application;
FIG. 2 is a diagram of a partial structure of an electronic device according to an embodiment of this application;
FIG. 3 is a diagram of a structure of an integrated circuit according to an embodiment of this application;
FIG. 4 is a sectional view of the integrated circuit shown in FIG. 3 in an A-A direction;
FIG. 5 is a diagram of another structure of an integrated circuit according to an embodiment of this application;
FIG. 6 and FIG. 7 show structures corresponding to steps in a preparation method for an integrated circuit in a possible implementation;
FIG. 8 is a flowchart of a preparation method for an integrated circuit according to an embodiment of this application;
FIG. 9a is a diagram of a structure of an initial integrated circuit according to an embodiment of this application;
FIG. 9b is a diagram of another structure of an initial integrated circuit according to an embodiment of this application;
FIG. 9c is a diagram of still another structure of an initial integrated circuit according to an embodiment of this application;
FIG. 10a to FIG. 10n are diagrams of structures corresponding to steps in a preparation method for an integrated circuit according to an embodiment of this application; and
FIG. 11a to FIG. 11f are diagrams of structures corresponding to steps in another preparation method for an integrated circuit according to an embodiment of this application.

### DESCRIPTION OF EMBODIMENTS

The following describes technical solutions in embodiments of this application with reference to accompanying drawings in embodiments of this application. It is clear that the described embodiments are merely a part but not all of embodiments of this application. All other embodiments obtained by a person of ordinary skill in the art based on embodiments of this application shall fall within the protection scope of this application.

In descriptions of embodiments of this application, unless otherwise specified, "a plurality of" means two or more. "At least one of the items (pieces)" or a similar expression thereof indicates any combination of these items, including a single item (piece) or any combination of a plurality of items (pieces). For example, at least one of a, b, and c may indicate a, b, c, a and b, a and c, b and c, or a, b, and c, where a, b, and c may be singular or plural.

"And/or" describes an association relationship between associated objects, and indicates that three relationships may exist. For example, a and/or b may indicate the following cases: Only a exists, both a and b exist, and only b exists, where a and b may be singular or plural. The character "/" generally indicates an "or" relationship between the associated objects.

In addition, to clearly describe the technical solutions in embodiments of this application, terms such as "first" and "second" are used in embodiments of this application to distinguish between same items or similar items that provide basically same functions or purposes. A person skilled in the art may understand that the terms such as "first" and "second" do not limit a quantity or an execution sequence, and the terms such as "first" and "second" do not indicate a definite difference. In addition, in embodiments of this application, terms such as "example" or "for example" indicate giving an example, an illustration, or a description. Any embodiment or design scheme described as an "example" or "for example" in embodiments of this application should not be explained as being more preferred or having more advantages than another embodiment or design scheme. Exactly, use of the terms such as "example" or "for example" is intended to present a related concept in a specific manner for ease of understanding.

In descriptions of some embodiments, expressions of "connect" and extensions thereof are used. The term "connect" should be understood in a broad sense. For example, "connect" may be a fixed connection, a detachable connection, or an integral connection, and may be a direct connection or an indirect connection through an intermediate medium. In addition, use of "based on" means openness and inclusiveness, because a process, a step, calculation, or another action "based on" one or more conditions or values may be based in practice on additional conditions or values beyond the described values.

In embodiments of this application, "parallel", "perpendicular", "equal", and "flush" include described cases and cases similar with the described cases. A range of a similar case is within an acceptable deviation range. The acceptable deviation range is determined by a person of ordinary skill in the art by considering an error (namely, a limitation of a measurement system) related to measurement being discussed and measurement of a specific quantity. For example, "parallel" includes "absolutely parallel" and "approximately parallel", and an acceptable deviation range of "approximately parallel" may be, for example, a deviation within 5°. "Perpendicular" includes "absolutely perpendicular" and "approximately perpendicular", and an acceptable deviation range of "approximately perpendicular" may also be, for example, the deviation within 5°. "Equal" includes "absolutely equal" and "approximately equal", and an acceptable deviation range of "approximately equal" may be that, for example, a difference between two equal objects is less than or equal to 5% of either of the two objects. "Flush" includes "absolutely flush" and "approximately flush", and an acceptable deviation range of "approximately flush" may be determined, for example, based on an actual process.

In embodiments of this application, "upper", "lower", "front", and "right" may include but are not limited to being defined relative to illustrative orientations in which components are placed shown in the accompanying drawings. It should be understood that these orientation terms may be relative concepts and are used for relative descriptions and clarifications, and may vary accordingly based on a change of the orientations in which the components are placed in the accompanying drawings. In the accompanying drawings, for clarity, thicknesses of a layer and a region are exaggerated, and a size proportion relationship between parts in the figures does not reflect an actual size proportion relationship. Therefore, a change of a shape in the accompanying drawings due to, for example, manufacturing techniques and/or tolerances may be envisaged. Therefore, example implementations should not be explained as being limited to a shape of a region shown in this application, but rather include shape deviations due to, for example, manufacturing. For example, an etching region shown as a rectangle typically has a curved feature. Therefore, the regions shown in the accompanying drawings are essentially examples, and shapes of the regions are not intended to show actual shapes of regions of a device, and are not intended to limit a scope of the example implementations.

In addition, an architecture and a scenario described in embodiments of this application are intended to describe the technical solutions in embodiments of this application more clearly, and do not constitute a limitation on the technical solutions provided in embodiments of this application. A person of ordinary skill in the art may learn that, with evolution of architectures and emergence of new scenarios, the technical solutions provided in embodiments of this application are also applicable to a similar technical problem.

An embodiment of this application provides an electronic device. The electronic device may be a mobile phone (mobile phone), a tablet computer (pad), a television, a desktop computer, a laptop computer, a handheld computer, a notebook computer, an ultra-mobile personal computer (ultra-mobile personal computer, UMPC), a netbook, a cellular phone, a personal digital assistant (personal digital assistant, PDA), an augmented reality (augmented reality, AR) device, a virtual reality (virtual reality, VR) device, an artificial intelligence (artificial intelligence, AI) device, a smart wearable device (for example, a smartwatch or a smart band), a vehicle-mounted device, a smart home device, and/or a smart city device. A specific type of the electronic device is not specifically limited in embodiments of this application.

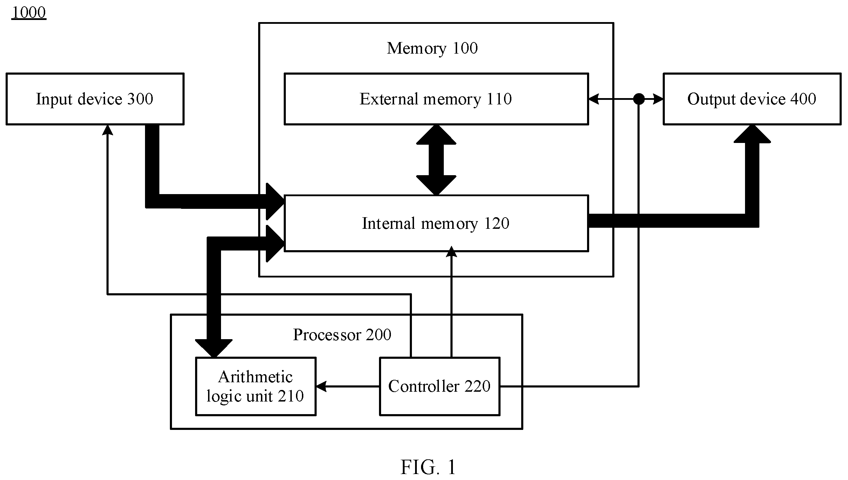

FIG. 1 is a diagram of an architecture of an electronic device according to an embodiment of this application. As shown in FIG. 1, the electronic device 1000 includes components such as a memory 100, a processor 200, an input device 300, and an output device 400. A person skilled in the art may understand that a structure of the electronic device shown in FIG. 1 does not constitute any limitation on the electronic device 1000. The electronic device 1000 may include more or fewer components than those shown in FIG. 1, may combine some of the components shown in FIG. 1, or may have a different component arrangement from that shown in FIG. 1.

The memory 100 is configured to store a software program and a module. The memory 100 mainly includes a program storage region and a data storage region. The program storage region may store an operating system, an application required by at least one function (for example, a sound playing function and an image playing function), and the like. The data storage region may store data (for example, audio data, image data, and a phone book) created based on use of the electronic device, and the like. In addition, the memory 100 includes an external memory 110 and an internal memory 120. Data stored in the external memory 110 and the internal memory 120 may be transmitted to each other. The external memory 110 includes, for example, a hard disk, a USB flash drive, and a floppy disk. The internal memory 120 includes, for example, a static random access memory (static random access memory, SRAM), a dynamic random access memory (dynamic random access memory, DRAM), a read-only memory, and the like.

The processor 200 is a control center of the electronic device 1000, is connected to various parts of the entire electronic device 1000 through various interfaces and lines, and executes various functions of the electronic device 1000 and processes data by running or executing the software program and/or the module that are stored in the memory 100 and invoking data stored in the memory 100, to perform overall monitoring on the electronic device 1000. Optionally, the processor 200 may include one or more processing units. For example, the processor 200 may include a central processing unit (central processing unit, CPU), an artificial intelligence (artificial intelligence, AI) processor, a digital signal processor (digital signal processor, DSP), and a neural-network processing unit, or may be another application-specific integrated circuit (application-specific integrated circuit, ASIC). In FIG. 1, an example in which the processor 200 is a CPU is used, and the CPU may include an arithmetic logic unit 210 and a controller 220. The arithmetic logic unit 210 obtains data stored in the internal memory 120, and processes the data stored in the internal memory 120. A processed result is usually sent back to the internal memory 120. The controller 220 may control the arithmetic logic unit 210 to process the data, and the controller 220 may further control the external memory 110 and the internal memory 120 to store data or read data. The memory 100 may store data generated by the processor 200.

The input device 300 is configured to receive input number or character information, and generate a button signal input related to a user setting and function control of the electronic device 1000. For example, the input device 300 may include a touchscreen and another input device. The touchscreen, also referred to as a touch panel, may collect a touch operation performed by a user on the touchscreen or near the touchscreen (for example, an operation performed by the user on the touchscreen or near the touchscreen by using any suitable object or accessory such as a finger or a stylus), and drive a corresponding connection apparatus based on a preset program. Optionally, the touchscreen may include two parts: a touch detection apparatus and a touch controller. The touch detection apparatus detects a touch orientation of the user, detects a signal generated by the touch operation, and transmits the signal to the touch controller. The touch controller receives touch information from the touch detection apparatus, converts the touch information into touch point coordinates, and sends the touch point coordinates to the processor 200, and can receive and execute a command sent by the processor 200. In addition, the touchscreen may be implemented in a plurality of types such as a resistive type, a capacitive type, an infrared type, and a surface acoustic wave type. The another input device may include but is not limited to one or more of a physical keyboard, a function button (for example, a volume control button or a power button), a trackball, a mouse, a joystick, and the like. The controller 220 in the processor 200 may further control the input device 300 to receive an input signal or not to receive an input signal. In addition, the input number or character information received by the input device 300 and the button signal input related to the user setting and the function control of the electronic device may be stored in the internal memory 120.

The output device 400 is configured to output a signal corresponding to data that is input by the input device 300 and that is stored in the internal memory 120. For example, the output device 400 outputs a sound signal or a video signal. The controller 220 in the processor 200 may further control the output device 400 to output a signal or not to output a signal.

It should be noted that a bold arrow in FIG. 1 indicates data transmission, and a direction of the bold arrow indicates a data transmission direction. For example, a unidirectional arrow between the input device 300 and the internal memory 120 indicates that data received by the input device 300 is transmitted to the internal memory 120. For another example, a bidirectional arrow between the arithmetic logic unit 210 and the internal memory 120 indicates that the data stored in the internal memory 120 may be transmitted to the arithmetic logic unit 210, and data processed by the arithmetic logic unit 210 may be transmitted to the internal memory 120. A thin arrow in FIG. 1 indicates a component that can be controlled by the controller 220. For example, the controller 220 may control the external memory 110, the internal memory 120, the arithmetic logic unit 210, the input device 300, the output device 400, and the like.

Optionally, the electronic device 1000 shown in FIG. 1 may further include various sensors, for example, a gyroscope sensor, a hygrometer sensor, an infrared sensor, and a magnetometer sensor. Details are not described herein. Optionally, the electronic device 1000 may further include a wireless fidelity (wireless fidelity, Wi-Fi) module, a Bluetooth module, and the like. Details are not described herein.

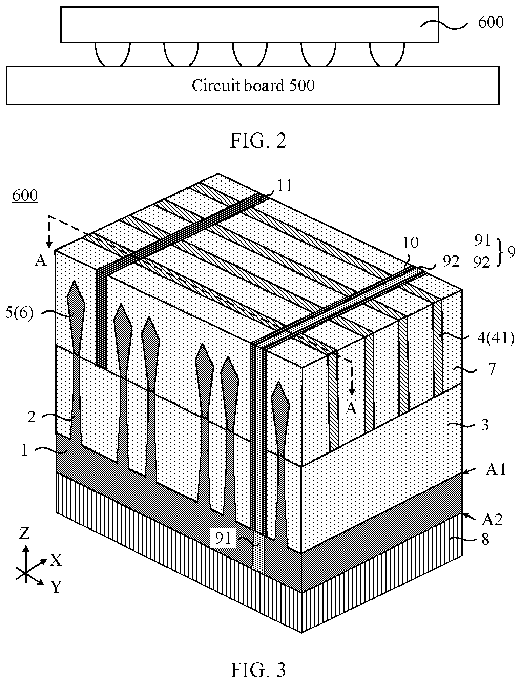

FIG. 2 shows a partial structure of the electronic device 1000. As shown in FIG. 2, the electronic device 1000 may further include a circuit board 500 and an integrated circuit 600. The integrated circuit 600 is disposed on the circuit board 500, and is electrically connected to the circuit board 500.

As shown in FIG. 2, the electronic device 1000 further includes a connection member disposed between the circuit board 500 and the integrated circuit 600, and the integrated circuit 600 is electrically connected to the circuit board 500 through the connection member. The connection member may be, for example, a ball grid array (ball grid array, BGA).

Optionally, another structure, for example, a package substrate, may be further disposed between the connection member and the circuit board 500. In other words, the integrated circuit 600 may be packaged on the package substrate, and then connected to the circuit board 500 through the package substrate.

There may be one or more integrated circuits 600. When there are a plurality of integrated circuits 600, the plurality of integrated circuits 600 may be tiled, or may be stacked.

The integrated circuit 600 may be a wafer, or may be a chip. When the integrated circuit 600 is a chip, the chip may be a bare die (which may also be referred to as a die or a particle) obtained by cutting a wafer, or may be a packaged chip obtained by packaging a bare die. Optionally, the integrated circuit 600 has a logical computing function. In this case, the integrated circuit 600 may be used in a logic device (for example, the arithmetic logic unit 210, the controller 220, and the sensor). Alternatively, the integrated circuit 600 has a storage function. In this case, the integrated circuit 600 may also be used in a storage device (for example, the external memory 110 and the internal memory 120). This is not limited in embodiments of this application.

Some embodiments of this application provide an integrated circuit and a preparation method therefor. With reference to accompanying drawings, the following separately schematically describes the integrated circuit and the preparation method for the integrated circuit.

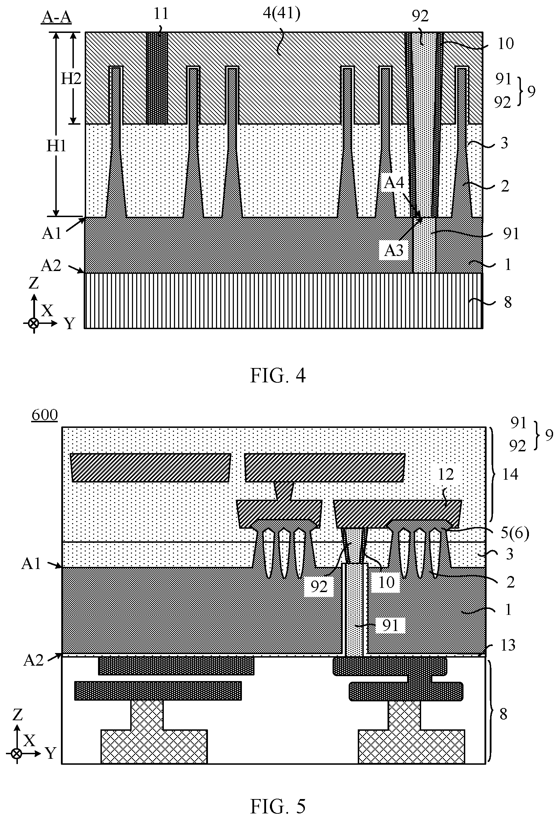

FIG. 3 and FIG. 5 separately show a structure of the integrated circuit. FIG. 4 shows a cross-sectional structure of the integrated circuit shown in FIG. 3 in an A-A direction.

As shown in FIG. 3, the integrated circuit 600 includes a substrate 1, fins 2, a second dielectric layer 3, a gate line 4, a source 5, a drain 6, an inter-layer dielectric layer 7, a power distribution network 8, and a power contact structure 9.

For example, a material of the substrate 1 includes a semiconductor material. The semiconductor material includes but is not limited to bulk silicon, bulk germanium, silicon germanium, silicon carbide, silicon-on-insulator (silicon-on-insulator, SOI), silicon-germanium-on-insulator (SiGe-on-insulator, SGOI), other group III and group V materials, or the like.

As shown in FIG. 3, FIG. 4, and FIG. 5, the substrate 1 has a first surface A1 and a second surface A2 that face away from each other. For example, both the first surface A1 and the second surface A2 are planes. The fin 2 is located on the first surface A1. Optionally, the fin 2 and the substrate 1 are of an integrated structure. In this case, the substrate 1 and the fin 2 may be synchronously obtained by etching a substrate.

There may be a plurality of fins 2, and for example, the plurality of fins 2 extend in a first direction X and are spaced apart in a second direction Y. In the plurality of fins 2, in the second direction Y, spacings between any two adjacent fins 2 may be equal or unequal. This may be specifically selected according to an actual requirement. Sizes (which may also be referred to as heights) of the fins 2 in a third direction Z may be equal or unequal. This may be specifically selected according to an actual requirement. Both the first direction X and the second direction Y are parallel to the first surface A1, and the third direction Z is perpendicular to the first surface A1. The first direction X intersects with the second direction Y. For example, the first direction X and the second direction Y are perpendicular to each other.

A quantity of the fins 2 may be selected according to an actual requirement. This is not limited in embodiments of this application, provided that function and structure requirements of the integrated circuit 600 can be met. For example, FIG. 3 shows six fins 2, and FIG. 5 shows eight fins 2.

As shown in FIG. 3 and FIG. 4, the second dielectric layer 3 is located between any two adjacent fins 2, and covers each fin 2. Herein, the second dielectric layer 3 may also be referred to as a shallow trench isolation (shallow trench isolation, STI) structure, and is configured to separate two adjacent fins 2, to implement isolation between adjacent components.

As shown in FIG. 3 and FIG. 4, the gate line 4 is located on the second dielectric layer 3, and is disposed across a plurality of fins 2. For example, the gate line 4 is disposed across three, six, eight, or more fins 2.

There are a plurality of gate lines 4, and for example, the plurality of gate lines 4 extend in the second direction Y and are spaced apart in the first direction X. In the plurality of gate lines 4, spacings between any two adjacent fins 2 may be equal or unequal. This may be specifically selected according to an actual requirement. Quantities of fins 2 across which different gate lines 4 are disposed may be equal or unequal. This may be specifically selected according to an actual requirement.

A quantity of the gate lines 4 may be selected according to an actual requirement. This is not limited in embodiments of this application, provided that the function and structure requirements of the integrated circuit 600 can be met.

As shown in FIG. 3 and FIG. 5, the source 5 and the drain 6 are located on the fin 2, and are located on two sides of the gate line 4. For example, the source 5 and the drain 6 may be formed on the fin 2 by using an epitaxial process.

With reference to FIG. 4 and FIG. 5, a part that is of the gate line 4 and that is disposed across the fin 2 is configured to form a gate, a part that is of the fin 2 and that is covered by the gate line 4 is configured to form a channel, and the gate, the channel, and the source 5 and the drain 6 that are located on two sides of the gate are configured to form a fin field-effect transistor (or a gate-all-around field-effect transistor). In other words, a same gate line 4 and a plurality of fins 2 across which the gate line 4 is disposed may form a plurality of fin field-effect transistors, and the gate line 4 may control the plurality of fin field-effect transistors to be conducted or cut off.

As shown in FIG. 3, the inter-layer dielectric layer 7 is located on the second dielectric layer 3, and is disposed across a plurality of fins 2. There are a plurality of inter-layer dielectric layers 7, and for example, the plurality of inter-layer dielectric layers 7 extend in the second direction Y and are spaced apart in the first direction X.

The inter-layer dielectric layer 7 and the gate line 4 are alternately disposed in the first direction X. This helps isolate adjacent gate lines 4 by using the inter-layer dielectric layer 7.

As shown in FIG. 3, FIG. 4, and FIG. 5, the power distribution network 8 is located on the second surface A2. As shown in FIG. 5, the power distribution network 8 includes a plurality of routing layers and a plurality of third dielectric layers. The plurality of routing layers and the plurality of third dielectric layers are alternately disposed, and traces in different routing layers can be connected through a through hole in the third dielectric layer. The power distribution network 8 includes, for example, components such as a power supply (VSS, VDD, or the like) and ground. The power distribution network 8 is mainly configured to provide an operating current and an operating voltage.

As shown in FIG. 3, FIG. 4, and FIG. 5, the power contact structure 9 penetrates the gate line 4, the second dielectric layer 3, and the substrate 1, and is located between two adjacent fins 2. A top end of the power contact structure 9 is electrically connected to a target electrode, and the target electrode is one of the source 5 and the drain 6. The power contact structure 9 may be electrically connected to a target electrode of one transistor, or may be electrically connected to target electrodes of a plurality of transistors. For example, the power contact structure 9 in FIG. 5 is electrically connected to target electrodes of four transistors. A bottom end of the power contact structure 9 is electrically connected to the power distribution network 8. The operating current and the operating voltage that are provided by the power distribution network 8 may be transmitted, through the power contact structure 9, to the target electrode of the transistor electrically connected to the power contact structure 9, so that the transistor electrically connected to the power contact structure 9 works.

A material of the power contact structure 9 includes a metal material.

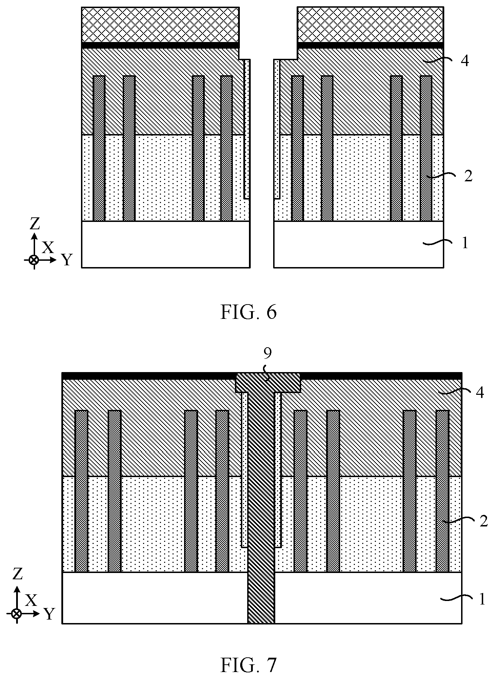

In a possible implementation, as shown in FIG. 6 and FIG. 7, the power contact structure 9 is of an integrated structure. In a process of preparing and forming the power contact structure 9, a trench (or a through hole or a deep hole) may be first formed through etching, and then the trench is filled with the metal material. Because an aspect ratio of the power contact structure 9 is very large, this undoubtedly increases difficulty of an etching process and difficulty of a metal filling process.

In addition, disposition of a structure, for example, a buried power rail, reduces a spacing between the power contact structure 9 and an existing structure in the integrated circuit. For example, with miniaturization of the integrated circuit, a spacing between two adjacent fins 2 is reduced. Process difficulty of alignment, photolithography, etching, and the like required for performing etching between two fins 2 that are very close to each other to form a trench is high. In addition, when a deviation exists in a process, for example, alignment, photolithography, etching, or metal filling, the fin 2 or the gate line 4 is likely to be damaged, and this is likely to reduce reliability and a yield of the integrated circuit.

Based on this, still refer to FIG. 3, FIG. 4, and FIG. 5. The power contact structure 9 in this embodiment of this application includes a first power contact portion 91 and a second power contact portion 92. In a direction from the second surface A2 to the first surface A1 (namely, a forward direction of the third direction Z), the first power contact portion 91 and the second power contact portion 92 are sequentially disposed, and the second power contact portion 92 is located above the first power contact portion 91. A bottom end of the first power contact portion 91 is connected to the power distribution network 8, a top end of the first power contact portion 91 is connected to a bottom end of the second power contact portion 92, and a top end of the second power contact portion 92 is electrically connected to the target electrode. An electrical signal may be transmitted between the first power contact portion 91 and the second power contact portion 92.

Optionally, the top end of the second power contact portion 92 may be directly electrically connected to the target electrode. Alternatively, the top end of the second power contact portion 92 may be indirectly electrically connected to the target electrode. In other words, the top end of the second power contact portion 92 and the target electrode may be routed through another structure. According to a power supply requirement, when the top end of the second power contact portion 92 and the target electrode are routed through the another structure, the top end of the second power contact portion 92 may be connected to different metal structures such as M0 and V0. Further, the top end of the second power contact portion 92 may be further connected to a metal structure in an interconnection layer or another routing layer mentioned below.

Both an aspect ratio of the first power contact portion 91 and an aspect ratio of the second power contact portion 92 are less than the aspect ratio of the power contact structure 9. In a direction perpendicular to the first surface A1, a height of the first power contact portion 91 is greater than a height of the second power contact portion 92 may be the same or different.

A material of the first power contact portion 91 includes but is not limited to one or a combination of a plurality of tungsten, copper, cobalt, titanium nitride, titanium, tantalum, tantalum nitride, ruthenium, ruthenium nitride, and aluminum. A material of the second power contact portion 92 includes but is not limited to one or a combination of a plurality of tungsten, copper, cobalt, titanium nitride, titanium, tantalum, tantalum nitride, ruthenium, ruthenium nitride, and aluminum. Materials of the first power contact portion 91 and the second power contact portion 92 may be the same or different.

The power contact structure 9 is divided into the first power contact portion 91 and the second power contact portion 92, so that a forming process of the power contact structure 9 may be split, and the power contact structure 9 may be prepared and formed in two steps. For example, a trench (or a through hole, a deep hole, or the like) configured to accommodate the second power contact portion 92 may be first formed, and the trench is filled with a metal material, to form the second power contact portion 92. Then, a trench (or a through hole, a deep hole, or the like) configured to accommodate the first power contact portion 91 is formed, and the trench is filled with a metal material, to form the first power contact portion 91. Because both the aspect ratio of the first power contact portion 91 and the aspect ratio of the second power contact portion 92 are small, difficulty of an etching process and a metal filling process that are required for preparing the first power contact portion 91 is low, and difficulty of an etching process and a metal filling process that are required for preparing the second power contact portion 92 is low, and therefore, process difficulty of forming the power contact structure 9 can be reduced.

Still refer to FIG. 3, FIG. 4, and FIG. 5. The integrated circuit 600 provided in this embodiment of this application further includes an isolation layer 10. The isolation layer 10 is located on the substrate 1, and is located between two adjacent fins 2. The isolation layer 10 extends, for example, in the first direction X, and penetrates at least parts of the gate line 4 and the second dielectric layer 3. For example, the isolation layer 10 divides the gate line 4 into a plurality of gate sub-lines 41. The isolation layer 10 is located between two adjacent gate sub-lines 41 in a same gate line 4.

A material of the isolation layer 10 includes a dielectric material, so that two gate sub-lines 41 obtained through division by a same isolation layer 10 are electrically insulated. Optionally, the dielectric material includes but is not limited to silicon oxide (OX), silicon nitride (SiN), and the like.

There are a plurality of isolation layers 10, and the plurality of isolation layers 10 are spaced apart. Quantities of gate lines 4 divided by different isolation layers 10 may be equal or unequal. This may be specifically selected according to an actual requirement. For example, each isolation layer 10 divides one gate line 4. Alternatively, as shown in FIG. 3, each isolation layer 10 divides four gate lines 4.

The foregoing transistor includes an N-type transistor and a P-type transistor. The isolation layer 10 is disposed, for example, between the N-type transistor and the P-type transistor.

As shown in FIG. 3, FIG. 4, and FIG. 5, the isolation layer 10 is located on two opposite sides of the second power contact portion 92 in the second direction Y. In the second direction Y, the isolation layer 10 may separate the second power contact portion 92 from structures (for example, the gate sub-line 41 and the fin 2) on two sides of the second power contact portion 92.

Further, the isolation layer 10 is located on two opposite sides of the second power contact portion 92 in the first direction X. In other words, the isolation layer 10 is ring-shaped and surrounds the second power contact portion 92.

The isolation layer 10 is configured to provide a self-alignment function for the second power contact portion 92. Before the second power contact portion 92 is formed through filling, the isolation layer 10 may be first formed in the trench configured to accommodate the second power contact portion 92. In this way, in a process of forming the second power contact portion 92 through filling, the material of the second power contact portion 92 can be naturally filled in a region defined by the isolation layer 10, to avoid damage to the fin 2 or the gate line 4. This helps reduce the difficulty of the metal filling process, and improve the reliability and the yield of the integrated circuit 600.

In addition, the isolation layer 10 has a specific thickness, so that the gate sub-line 41 can be electrically insulated from the second power contact portion 92 through the isolation layer 10. Disposition of the isolation layer 10 may reduce a precision requirement of the process, for example, alignment, photolithography, or etching, to reduce difficulty of the process, for example, alignment, photolithography, or etching. The thickness of the isolation layer 10 may be selected according to an actual product requirement.

It may be understood that, as shown in FIG. 4, the first power contact portion 91 has a surface on a side close to the second power contact portion 92, and the surface is defined, for example, as a third surface A3. The second power contact portion 92 has a surface on a side close to the first power contact portion 91, and the surface is defined, for example, as a fourth surface A4. There is a connection surface between the first power contact portion 91 and the second power contact portion 92. The connection surface is located within both the third surface A3 and the fourth surface A4.

In some examples, as shown in FIG. 4, the connection surface is further located within the first surface A1. In other words, both the third surface A3 and the fourth surface A4 are flush with the first surface A1. The first surface A1 may also be considered as a connection surface between the substrate 1 and the second dielectric layer 3.

The trench configured to accommodate the first power contact portion 91 is etched, for example, starting from a side on which the second surface A2 of the substrate 1 is located. The material of the substrate 1 and a material of the second dielectric layer 3 are different. Compared with the substrate 1, the second dielectric layer 3 is more suitable for being used as an etching stop layer, so that etching of the trench configured to accommodate the first power contact portion 91 more easily stops at the second dielectric layer 3.

Certainly, the connection surface may alternatively be located near the first surface A1. For example, as shown in FIG. 5, the connection surface is located above the first surface A1, and is slightly higher than the first surface A1. In this case, in a process of forming the trench configured to accommodate the first power contact portion 91, the substrate 1 may be slightly over-etched, so that the trench extends into the second dielectric layer 3. For another example, the connection surface is located below the first surface A1, and is slightly higher than the first surface A1. In this case, in a process of forming the trench configured to accommodate the first power contact portion 91, the trench may be etched only until exposing the fourth surface A4, or may be slightly over-etched to penetrate the substrate 1.

In some examples, as shown in FIG. 4, an orthogonal projection of the fourth surface A4 on the first surface A1 is located within a range of an orthogonal projection range of the third surface A3 on the first surface A1.

For example, a part of a boundary of the orthogonal projection of the fourth surface A4 on the first surface A1 coincide with a part of a boundary of the orthogonal projection of the third surface A3 on the first surface A1, and there is a spacing between the other part of the boundary of the orthogonal projection of the fourth surface A4 on the first surface A1 and the other part of the boundary of the orthogonal projection of the third surface A3 on the first surface A1. Alternatively, there is a spacing between the boundary of the orthogonal projection of the fourth surface A4 on the first surface A1 and the boundary of the orthogonal projection of the third surface A3 on the first surface A1.

In any direction parallel to the first surface A1, a size of the fourth surface A4 is less than a size of the third surface A3.

In this way, there can be a large contact area between the first power contact portion 91 and the second power contact portion 92. In addition, difficulty of aligning the first power contact portion 91 and the second power contact portion 92 can be further reduced, a yield of connection between the first power contact portion 91 and the second power contact portion 92 can be improved, and stability of the integrated circuit 600 can be improved.

In some embodiments, as shown in FIG. 3 and FIG. 4, the integrated circuit 600 provided in this embodiment of this application further includes a gate cut structure 11. The gate cut structure 11 is located on the substrate 1, and is located between two adjacent fins 2. The gate cut structure 11 extends, for example, in the first direction X, and penetrates the gate line 4. The gate cut structure 11 is located, for example, on the second dielectric layer 3, and is in contact with a surface on a side that is of the second dielectric layer 3 and that is away from the substrate 1. The gate cut structure 11 also divides the gate line 4 into a plurality of gate sub-lines 41. The gate cut structure 11 is located between two adjacent gate sub-lines 41 in a same gate line 4. The gate cut structure 11 and the isolation layer 10 are spaced apart. Relative positions of the gate cut structure 11 and the isolation layer 10 may be selected according to an actual requirement.

A material of the gate cut structure 11 includes a dielectric material, so that two gate sub-lines 41 obtained through division by a same gate cut structure 11 are electrically insulated. Optionally, the dielectric material includes but is not limited to silicon oxide, silicon nitride, and the like.

There are a plurality of gate cut structures 11, and quantities of gate lines 4 divided by different gate cut structures 11 may be equal or unequal. This may be specifically selected according to an actual requirement. The quantity of gate lines 4 divided by the gate cut structure 11 and the quantity of gate lines 4 divided by the isolation layer 10 may be the same or different.

A division position of the gate cut structure 11 may be selected according to an actual requirement. Optionally, the division position of the gate cut structure 11 is disposed based on a type of the fin field-effect transistor. The gate cut structure 11 is disposed, for example, between the N-type transistor and the P-type transistor, and separates the N-type transistor and the P-type transistor that are adjacent to each other, to facilitate preparation of different types of transistors and help implement independent control of different types of transistors.

In some examples, the gate cut structure 11 and the isolation layer 10 are made of a same material, and are disposed on a same layer.

It should be noted that the "same layer" refers to a layer structure formed by using a same mask and a single patterning process after using a uniform film formation process to form a film layer for forming a specific pattern. Based on different specific patterns, the single patterning process may include a plurality of etching process steps. Specific patterns in the formed layer structure may be continuous or discontinuous, and these specific patterns may also be at different heights or have different thicknesses.

In other words, the gate cut structure 11 and the isolation layer 10 are formed by patterning a same thin film. In this embodiment of this application, a preparation process of the isolation layer 10 is integrated with a preparation process of the gate cut structure 11, so that a plurality of structures such as the gate cut structure 11 and the isolation layer 10 can be synchronously formed in the single patterning process, and this helps simplify a preparation process of the integrated circuit 600.

In some examples, as shown in FIG. 4, a height H1 of the isolation layer 10 is greater than a thickness H2 of the gate cut structure 11 in the direction perpendicular to the first surface A1. Herein, the "height H1 of the isolation layer 10" refers to a spacing, in the direction perpendicular to the first surface A1, between a surface on a side that is of the isolation layer 10 and that is close to the substrate 1 and a surface on a side that is of the isolation layer 10 and that is away from the substrate 1.

In this way, in a process of forming, through deposition, the thin film on which the isolation layer 10 and the gate cut structure 11 are located, it can be ensured that the thin film fully fills a trench configured to accommodate the gate cut structure 11, and it can also be ensured that the thin film fills only a part of the trench configured to accommodate the second power contact portion 92, to reserve space for the second power contact portion 92.

After the thin film is formed, a self-alignment function may be provided in the reserved space, so that the second power contact portion 92 is formed in the reserved space. Therefore, a preparation process of the second power contact portion 92 may also be integrated with the preparation process of the gate cut structure 11, to simplify the preparation process of the integrated circuit 600.

In some embodiments, as shown in FIG. 5, the integrated circuit 600 provided in this embodiment of this application further includes an epitaxial contact structure 12. The epitaxial contact structure 12 is located on the second power contact portion 92 and the target electrode, and is in contact with the second power contact portion 92 and the target electrode.

A material of the epitaxial contact structure 12 includes, for example, a metal material. A position of the epitaxial contact structure 12 may be determined according to an actual wiring requirement. This is not limited in embodiments of this application. Optionally, as shown in FIG. 5, the epitaxial contact structure 12 is located on the interconnection layer mentioned below.

The epitaxial contact structure 12 may be used as a bridge structure between the second power contact portion 92 and the target electrode, to reduce difficulty of electrical connection between the second power contact portion 92 and the target electrode. In this case, the operating current and the operating voltage provided by the power distribution network 8 may be transmitted, sequentially through the first power contact portion 91, the second power contact portion 92, and the epitaxial contact structure 12, to a target electrode electrically connected to the epitaxial contact structure 12, so that a transistor electrically connected to the epitaxial contact structure 12 works.

In some embodiments, as shown in FIG. 5, the integrated circuit 600 provided in this embodiment of this application further includes a first dielectric layer 13. The first dielectric layer 13 is located between the second surface A2 and the power distribution network 8, and is located between the first power contact portion 91 and the substrate 1. A surface on a side that is of the first power contact portion 91 and that is away from the second power contact portion 92 is flush with a surface on a side that is of the first dielectric layer 13 and that is away from the second surface A2.

A material of the first dielectric layer 13 includes a dielectric material, and the dielectric material includes but is not limited to silicon oxide, silicon nitride, and the like. The first dielectric layer 13 separates the first power contact portion 91 from the substrate 1, so that the first power contact portion 91 can be electrically insulated from the substrate 1. The first dielectric layer 13 separates the power distribution network 8 from the substrate 1, so that the power distribution network 8 can be electrically insulated from the substrate 1.

In some embodiments, as shown in FIG. 5, the integrated circuit 600 provided in this embodiment of this application further includes the interconnection layer 14. The interconnection layer 14 is located on a side that is of the epitaxial contact structure 12 and that is away from the substrate 1. The interconnection layer 14 is configured to interconnect various elements (for example, a transistor, a capacitor, and a resistor) on the substrate 1.

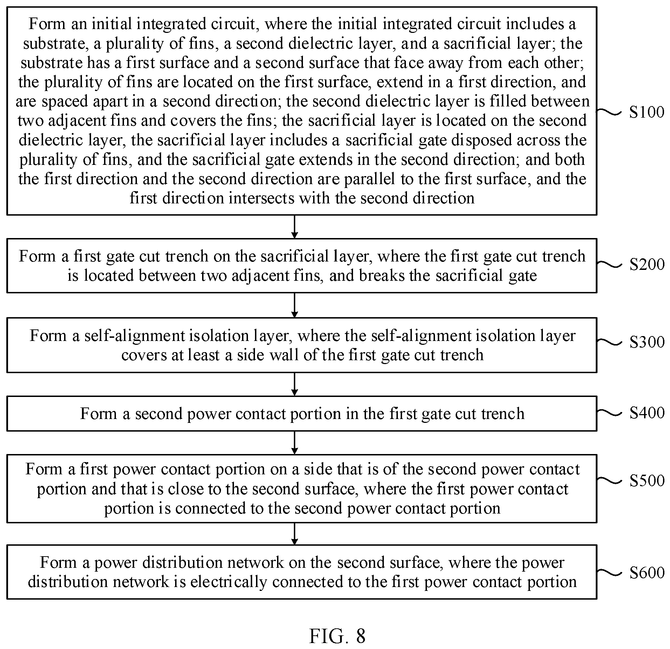

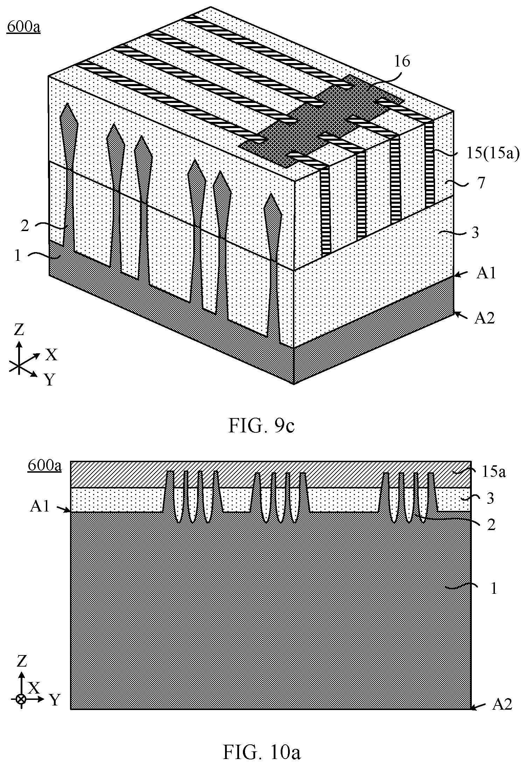

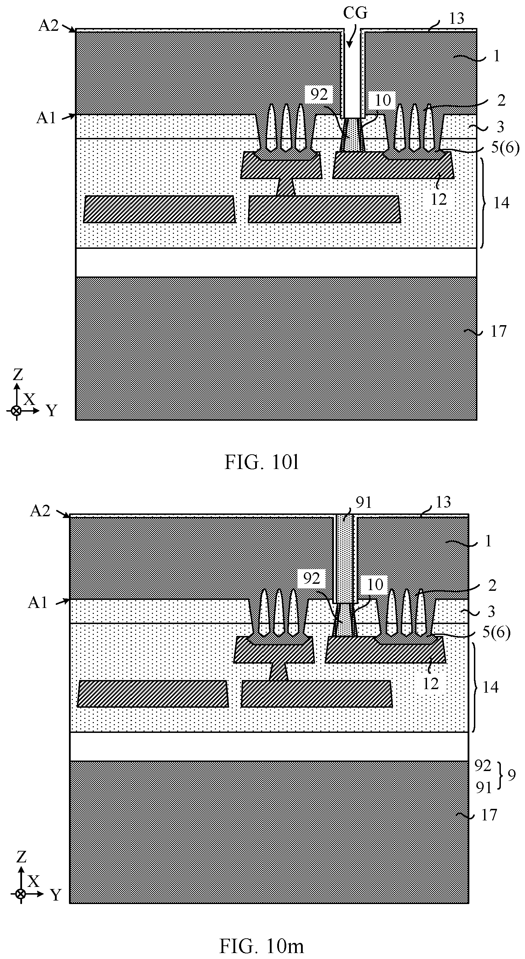

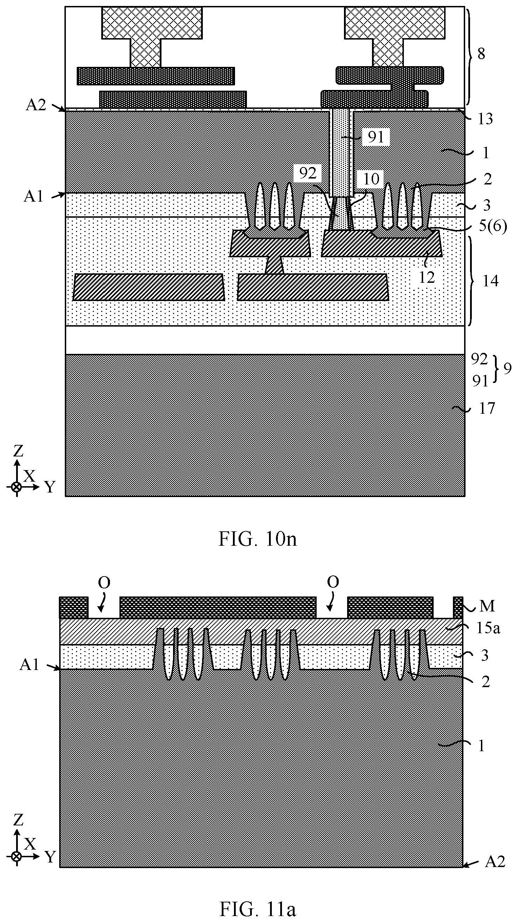

Some embodiments of this application further provide a preparation method for an integrated circuit. The preparation method is used, for example, to prepare and form the integrated circuit 600 according to any one of the foregoing examples. FIG. 8 is a schematic flowchart of a preparation method for an integrated circuit. FIG. 10a to FIG. 10m show structures corresponding to steps in a preparation method for an integrated circuit. FIG. 11a to FIG. 11f show structures corresponding to steps in another preparation method for an integrated circuit. It should be understood that the steps shown in FIG. 8 are not exclusive, and another step may be further performed before, after, or between any step in the steps shown in FIG. 8. In addition, some of the steps may be performed simultaneously, or may be performed in a sequence different from that shown in FIG. 8.

With reference to accompanying drawings, the following schematically describes the preparation method for the integrated circuit. As shown in FIG. 8, the preparation method includes S100 to S600.

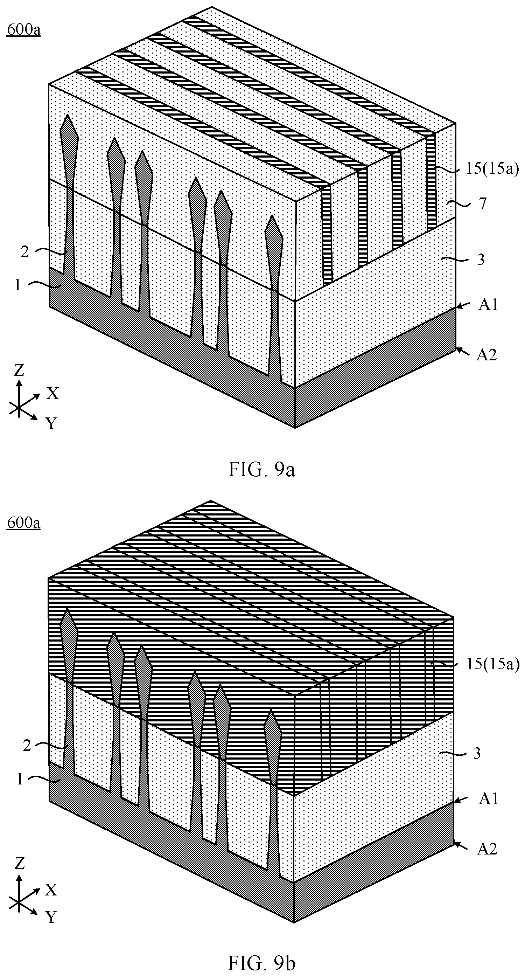

S100: As shown in FIG. 9a to FIG. 9c, form an initial integrated circuit 600a, where the initial integrated circuit 600a includes a substrate 1, a plurality of fins 2, a second dielectric layer 3, and a sacrificial layer 15; the substrate 1 has a first surface A1 and a second surface A2 that face away from each other; the plurality of fins 2 are located on the first surface A1, extend in a first direction X, and are spaced apart in a second direction Y; the second dielectric layer 3 is filled between two adjacent fins 2 and covers the fins 2; the sacrificial layer 15 is located on the second dielectric layer 3, the sacrificial layer 15 includes a sacrificial gate 15a disposed across the plurality of fins 2, and the sacrificial gate 15a extends in the second direction Y; and both the first direction X and the second direction Y are parallel to the first surface A1, and the first direction X intersects with the second direction Y.

It may be understood that, in different examples, the initial integrated circuit 600a may have a different structure. Herein, three structures of the initial integrated circuit 600a are schematically described with reference to the accompanying drawings. Certainly, the structure of the initial integrated circuit 600a is not limited thereto.

In some examples, as shown in FIG. 9a, there are a plurality of sacrificial gates 15a included in the sacrificial layer 15, and the plurality of sacrificial gates 15a are spaced apart in the first direction X. As shown in FIG. 9a, the initial integrated circuit 600 further includes a plurality of inter-layer dielectric layers 7, each inter-layer dielectric layers 7 extends in the second direction Y, and the plurality of inter-layer dielectric layers 7 and the plurality of sacrificial gates 15a are alternately disposed.

For example, a method for forming the sacrificial layer 15 includes: forming a sacrificial thin film on the second dielectric layer 3; then removing a part of the sacrificial thin film within a preset region, and forming the plurality of sacrificial gates 15a by a reserved part of the sacrificial thin film; and then forming the inter-layer dielectric layer 7 between two adjacent sacrificial gates 15a.

In some other examples, the sacrificial layer 15 is of an integrated structure. As shown in FIG. 9b, two adjacent sacrificial gates 15a are continuous and not separated. In this case, after a first gate cut trench (as described below) is formed, a part of a structure between the two adjacent sacrificial gates 15a may be replaced with an inter-layer dielectric layer.

In some other examples, as shown in FIG. 9c, there are a plurality of sacrificial gates 15a included in the sacrificial layer 15, the plurality of sacrificial gates 15a are spaced apart in the first direction X, and for example, at least one sacrificial gate 15a is broken. As shown in FIG. 9c, the initial integrated circuit 600 further includes a plurality of inter-layer dielectric layers 7, each inter-layer dielectric layers 7 extends in the second direction Y, and the plurality of inter-layer dielectric layers 7 and the plurality of sacrificial gates 15a are alternately disposed. Further, the initial integrated circuit 600 further includes an isolation portion 16, and the isolation portion 16 is disposed at a broken position of the sacrificial gate 15a. The first gate cut trench (as described below) is also formed, for example, at the broken position of the sacrificial gate 15a.

A material of the sacrificial layer 15 includes a plurality of materials, provided that the material can be easily etched and easily removed. Optionally, the material of the sacrificial layer 15 is not limited to polycrystalline silicon, amorphous silicon, amorphous carbon, and the like.

For the substrate 1, the fin 2, and the second dielectric layer 3, refer to the foregoing related descriptions. Details are not described herein again.

FIG. 10a shows a cross-sectional structure of the initial integrated circuit. FIG. 10a may be considered as a cross-sectional structure of the initial integrated circuit shown in FIG. 9a or FIG. 9b in the second direction Y. In this embodiment of this application, the structure shown in FIG. 10a is used as an example to describe the preparation method for the integrated circuit.

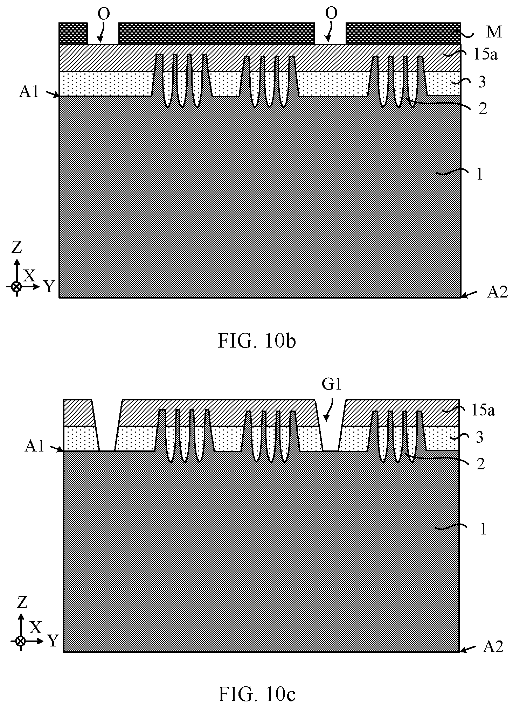

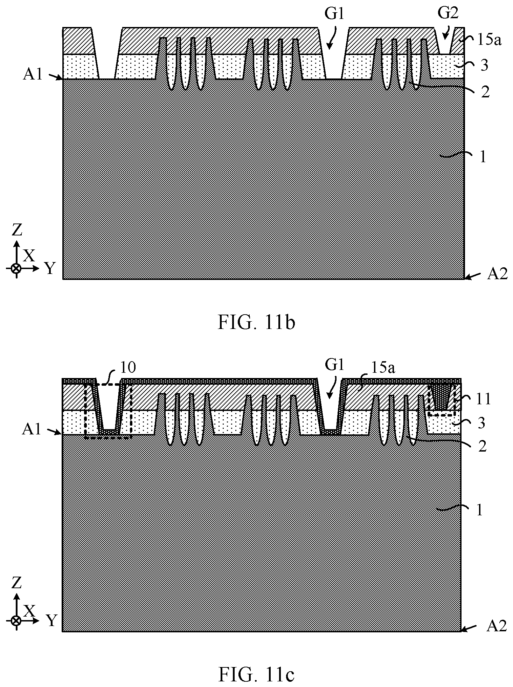

S200: As shown in FIG. 10b, FIG. 10c, FIG. 11a, and FIG. 11b, form a first gate cut trench G1 on the sacrificial layer 15, where the first gate cut trench G1 is located between two adjacent fins 2, and breaks the sacrificial gate 15a. For example, there are a plurality of first gate cut trenches G1, and the plurality of first gate cut trenches G1 are spaced apart.

The first gate cut trench G1 extends in the first direction X. When a size of the first gate cut trench G1 in the first direction X is small, the first gate cut trench G1 may also be referred to as a first gate cut through hole, a first gate cut deep hole, or the like. In this embodiment of this application, the trench is used as an example for description.

For example, a method for forming the first gate cut trench G1 includes S210 and S220.

S210: As shown in FIG. 10b and FIG. 11a, form a mask layer M on the sacrificial layer 15, where the mask layer M1 has a plurality of openings O, and a position of the opening O is the same as that of the to-be-formed first gate cut trench.

The mask layer M may be of a single-layer structure, or may be a structure formed by stacking a plurality of mask sub-layers. When the mask layer M is of the single-layer structure, a material of the mask layer M is, for example, photoresist. When the mask layer M is the structure formed by stacking the plurality of mask sub-layers, the plurality of mask sub-layers include, for example, at least one hard mask layer and at least one mask sub-layer that is formed by a photoresist material.

S220: As shown in FIG. 10c and FIG. 11b, etch the sacrificial layer 15 through the opening O using the mask layer M as a mask, to form a first gate cut trench G1.

Etching of the first gate cut trench G1 stops, for example, at the first surface A1 of the substrate 1. In other words, the first gate cut trench G1 penetrates the sacrificial gate 15a and the second dielectric layer 3 to the first surface A1.

Certainly, due to an inevitable process error or another reason, the etching of the first gate cut trench G1 may alternatively stop above the first surface A1. In this case, the first gate cut trench G1 does not completely penetrate the second dielectric layer 3, and there is a part of the second dielectric layer 3 between a bottom wall of the first gate cut trench G1 and the first surface A1. Alternatively, the etching of the first gate cut trench G1 may stop below the first surface A1. In this case, the first gate cut trench G1 completely penetrates the second dielectric layer 3 and extends into the substrate 1. A spacing between the bottom wall of the first gate cut trench G1 and the first surface A1 in a direction perpendicular to the first surface A1 may be determined based on an actual preparation process. This is not limited in embodiments of this application.

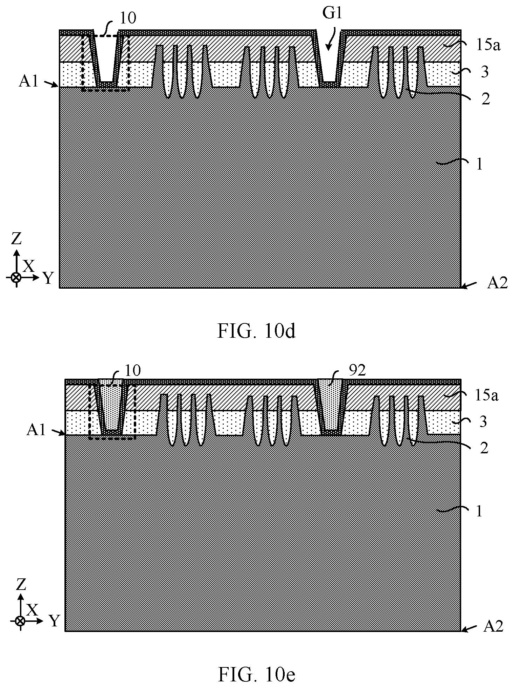

S300: As shown in FIG. 10d and FIG. 11c, form an isolation layer 10, where the isolation layer 10 covers at least a side wall of the first gate cut trench G1.

For example, in this embodiment of this application, the isolation layer 10 may be formed by using a deposition process or the like. The deposition process includes but is not limited to an atomic layer deposition process. The isolation layer 10 formed by using the atomic layer deposition process is uniform in thickness.

Optionally, the isolation layer 10 further covers the bottom wall of the first gate cut trench G1.

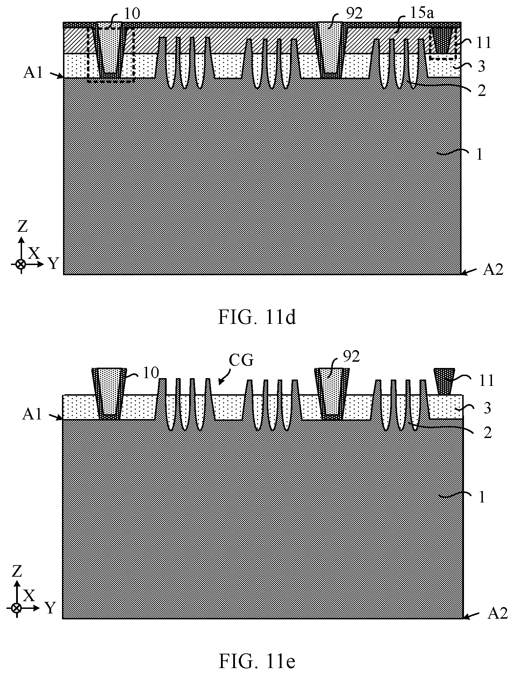

S400: As shown in FIG. 10e and FIG. 11d, form a second power contact portion 92 in the first gate cut trench G1.

For example, in this embodiment of this application, the first gate cut trench G1 may be filled with a metal material by using a metal filling process, to form a metal thin film, where the metal thin film further covers the sacrificial layer 15. Then, a part that is of the metal thin film and that covers the sacrificial layer 15 is removed through polishing by using a chemical-mechanical polishing process, and a part that is of the metal thin film and that is located in the first gate cut trench G1 is reserved, to obtain the second power contact portion 92.

The isolation layer 10 can provide a self-alignment function. In a process of filling the first gate cut trench G1 with the metal material, the metal material may naturally fill a region defined by the isolation layer 10, to avoid damage to the fin 2 or the gate line 4. This helps reduce difficulty of the metal filling process, and improve reliability and a yield of the integrated circuit 600.

In addition, the isolation layer 10 has a specific thickness, so that a gate sub-line 41 can be electrically insulated from the second power contact portion 92 through the isolation layer 10. This means that disposition of the isolation layer 10 may reduce a precision requirement of the process, for example, alignment, photolithography, or etching required for forming the first gate cut trench G1, to reduce difficulty of the process, for example, alignment, photolithography, or etching.

S500: As shown in FIG. 10m, form a first power contact portion 91 on a side that is of the second power contact portion 92 and that is close to the second surface A2, where the first power contact portion 91 is connected to the second power contact portion 92. The first power contact portion 91 and the second power contact portion 92 form, for example, a power contact structure 9.

For example, a method for forming the first power contact portion 91 on the side that is of the second power contact portion 92 and that is close to the second surface A2 includes S510 and S520.

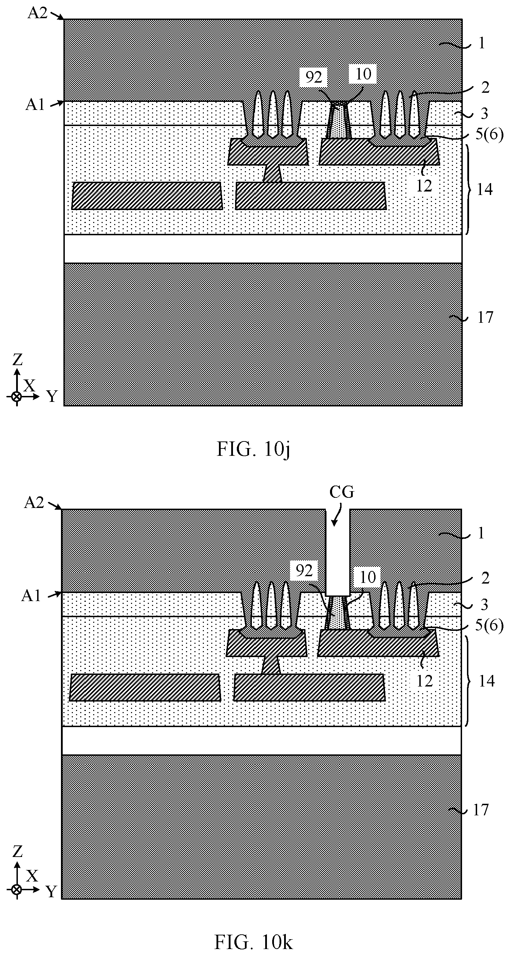

S510: As shown in FIG. 10k, etch the substrate 1 from a side on which the second surface A2 is located, to form a contact trench CG, where the contact trench CG exposes a surface on a side that is of the second power contact portion 92 and that is close to the second surface A2.

In any direction parallel to the first surface A1, a size of a bottom wall of the contact trench CG (namely, a surface that is of the contact trench CG and that is away from the second surface A2) is greater than, for example, a size of the surface on the side that is of the second power contact portion 92 and that is close to the second surface A2. In this way, even if there is a deviation in a position at which the contact trench CG is provided, it can be ensured that the contact trench CG can expose the surface on the side that is of the second power contact portion 92 and that is close to the second surface A2, and this helps reduce a precision requirement of a process required for forming the contact trench CG, so that there is a large contact area between the first power contact portion 91 and the second power contact portion 92 that are subsequently formed.

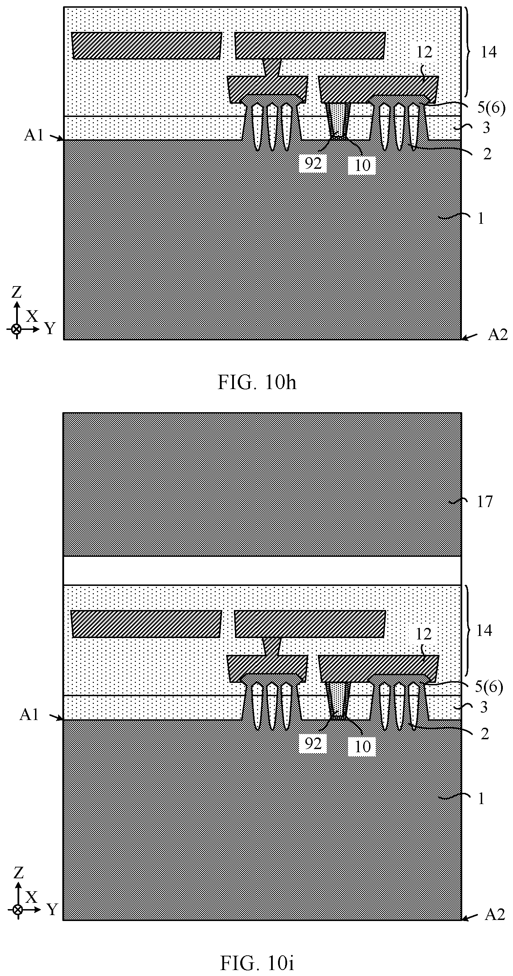

Optionally, before the contact trench CG is formed through etching, as shown in FIG. 10i and FIG. 10j, the initial integrated circuit may be first flipped, and the substrate 1 may be thinned. In the direction perpendicular to the first surface A1, a thickness of the substrate 1 may be reduced to 2 µm or less. For example, the thickness of the substrate 1 may be reduced to 2 µm, 1.8 µm, 1.5 µm, 1 µm, 0.5 µm, 0.1 µm, or the like. In this way, a depth of the contact trench CG can be reduced, so that difficulty of forming the contact trench CG through etching can be reduced.

The contact trench CG extends, for example, in the first direction X. When the size of the contact trench CG in the first direction X is small, the contact trench CG may also be referred to as a contact through hole, a contact deep hole, or the like. In this embodiment of this application, the trench is used as an example for description.

S520: As shown in FIG. 10m, form the first power contact portion 91 in the contact trench CG.

For example, in this embodiment of this application, the contact trench CG may be filled with a metal material by using the metal filling process, to form a metal thin film, where the metal thin film further covers the second surface A2 of the substrate 1. Then, a part that is of the metal thin film and that covers the second surface A2 is removed through polishing by using the chemical-mechanical polishing process, and a part that is of the metal thin film and that is located in the contact trench CG is reserved, to obtain the first power contact portion 91. The first power contact portion 91 is in direct contact with the second power contact portion 92 to form an electrical connection.

For example, when the isolation layer 10 further covers the bottom wall of the first gate cut trench G1, as shown in FIG. 10j, in the second direction Y, a cross-sectional pattern of the isolation layer 10 is in an inverted-"U" shape, and the isolation layer 10 is in contact with the surface on the side that is of the second power contact portion 92 and that is close to the second surface A2. In this case, as shown in FIG. 10k, before the first power contact portion 91 is formed in the contact trench CG, the preparation method further includes: removing, through the contact trench CG, a part that is of the isolation layer 10 and that covers the bottom wall of the first gate cut trench G1. In this way, the isolation layer 10 may be opened, to expose the surface on the side that is of the second power contact portion 92 and that is close to the second surface A2, so that the second power contact portion 92 is electrically connected to the first power contact portion 91.

Optionally, as shown in FIG. 101, before the first power contact portion 91 is formed, a first dielectric layer 13 may be further formed. The first dielectric layer 13 covers the side wall of the contact trench CG and the second surface A2, and exposes the second power contact portion 92. In this way, after the first power contact portion 91 is formed in the contact trench CG, the first dielectric layer 13 may separate the substrate 1 from the first power contact portion 91. Further, a surface on a side that is of the first power contact portion 91 and that is away from the second power contact portion 92 is flush with, for example, a surface on a side that is of the first dielectric layer 13 and that is away from the second surface A2.

S600: As shown in FIG. 10n, form a power distribution network 8 on the second surface A2. The power distribution network 8 is electrically connected to the first power contact portion 91.

Optionally, as shown in FIG. 10n, when the first dielectric layer 13 is formed, the power distribution network 8 is formed on the first dielectric layer 13. The first dielectric layer 13 separates the power distribution network 8 from the substrate 1.

It may be understood that, in the preparation method, the first gate cut trench G1 and the contact trench CG are prepared and formed independently of each other, and the second power contact portion 92 and the first power contact portion 91 are prepared and formed independently of each other. Both aspect ratios of the first gate cut trench G1 and the contact trench CG are small, and aspect ratios of the second power contact portion 92 and the first power contact portion 91 are also small. In comparison with the foregoing possible implementation, in the preparation method provided in this embodiment of this application, difficulty of etching processes required for the first gate cut trench G1 and the contact trench CG is reduced, and metal filling processes required for the second power contact portion 92 and the first power contact portion 91 are reduced. This means that, in the preparation method provided in this embodiment of this application, a preparation process of the power contact structure 9 is split, so that process difficulty can be effectively reduced as required.

In some embodiments, as shown in FIG. 11a and FIG. 11b, in S200, in a process of forming the first gate cut trench G1 on the sacrificial layer 15, a second gate cut trench G2 is further formed. The second gate cut trench G2 is located between two adjacent fins 2, and breaks the sacrificial gate 15a. In the direction perpendicular to the first surface A1, a depth of the second gate cut trench G2 is less than a depth of the first gate cut trench G1.

For example, there are a plurality of second gate cut trenches G2, and the plurality of second gate cut trenches G2 are spaced apart. Each second gate cut trench G2 and each first gate cut trench G1 are also spaced apart.

The first gate cut trench G1 and the second gate cut trench G2 may be formed, for example, in a same etching process (as shown in FIG. 11a and FIG. 11b), or may be formed in different etching processes. When the first gate cut trench G1 and the second gate cut trench G2 are formed in different etching processes, a sequence of forming the first gate cut trench G1 and the second gate cut trench G2 may be selected according to an actual requirement.

Etching of the second gate cut trench G2 stops, for example, at the second dielectric layer 3. In other words, the second gate cut trench G2 penetrates the sacrificial gate 15a to a surface on a side that is of the second dielectric layer 3 and that is away from the substrate 1.

In some embodiments, as shown in FIG. 11c, in S300, in a process of forming the isolation layer 10, a gate cut structure 11 is further formed. The gate cut structure 11 is located in the second gate cut trench G2.

For example, as shown in FIG. 11c, in this embodiment of this application, a dielectric material may be deposited in the first gate cut trench G1 and the second gate cut trench G2 by using an atomic layer deposition process, to form a dielectric thin film. A first portion of the dielectric thin film fully fills the second gate cut trench G2, a second portion of the dielectric thin film covers the bottom wall and the side wall of the first gate cut trench G1, and a third portion of the dielectric thin film covers the sacrificial layer 15. The first portion is configured to form the gate cut structure 11, the second portion is configured to form the isolation layer 10, and for example, the third portion is configured as a polishing stop layer for forming the second power contact portion 92. Alternatively, the third portion may be removed in a process of forming the second power contact portion 92 through polishing.

In this embodiment of this application, a preparation process of the isolation layer 10 is integrated with a preparation process of the gate cut structure 11, and a preparation process of the second power contact portion 92 is integrated with the preparation process of the gate cut structure 11, so that process procedures required for preparing the integrated circuit is effectively reduced, and a preparation process of the integrated circuit is simplified.

In some embodiments, before S600, that is, before the power distribution network 8 is formed on the second surface A2, the preparation method further includes S510 and S520.

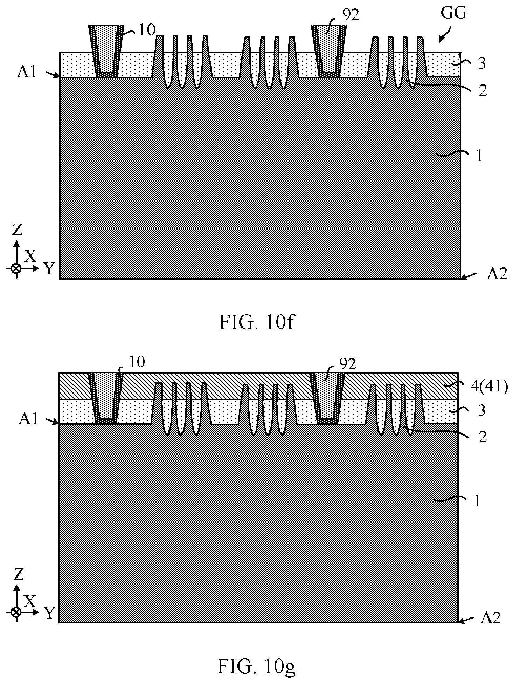

S510: As shown in FIG. 10e, FIG. 10f, FIG. 11d, and FIG. 11e, remove the sacrificial gate 15a to form a gate line trench GG, where the gate line trench GG exposes the second dielectric layer 3.

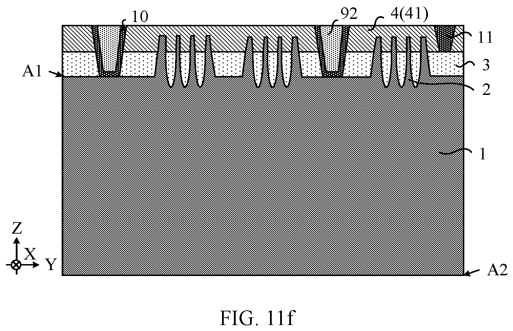

S520: As shown in FIG. 10g and FIG. 11f, fill the gate line trench GG with a conductive material, to form the gate line 4, and in this case, gate replacement is completed.

Optionally, before the gate line 4 is formed in the gate line trench GG, a structure, for example, a high-k dielectric layer and a work function layer may be further formed. This is not limited in embodiments of this application.

It can be learned from the foregoing that, in the preparation method provided in this embodiment of this application, the power contact structure 9 is first formed, and then gate replacement is performed. This process idea is different from the process idea in the foregoing possible implementation. This helps integrate the preparation process of the second power contact portion 92 in the power contact structure 9 with the preparation process of the gate cut structure 11. In addition, in this embodiment of this application, the gate line 4 can be prevented from being etched due to disposition of the second power contact portion 92, to further avoid damage to the gate line 4, so that a yield of the integrated circuit can be improved.

In some embodiments, as shown in FIG. 10h, after gate replacement is performed, the preparation method further includes: forming an epitaxial contact structure 12 on the second power contact portion 92 and a target electrode, where the epitaxial contact structure 12 is connected to the second power contact portion 92 and the target electrode; then forming an interconnection layer 14 on the epitaxial contact structure 12; and then binding (bonding) a bearing wafer 17 on the interconnection layer 14, where the bearing wafer 17 may be configured to support the integrated circuit.

Optionally, no element may be disposed on the bearing wafer 17. In this way, after the integrated circuit is prepared and formed, the bearing wafer 17 may be stripped and removed. Alternatively, a plurality of elements (for example, a transistor, a capacitor, and a resistor) may be formed on the bearing wafer 17, and the plurality of elements on the bearing wafer 17 are electrically connected to the interconnection layer 14. In this way, after the integrated circuit is prepared and formed, the bearing wafer 17 may be used as a part of the integrated circuit.

In the descriptions of this specification, the described specific features, structures, materials, or characteristics may be combined in a proper manner in any one or more of embodiments or examples. The foregoing descriptions are merely specific implementations of this application, but are not intended to limit the protection scope of this application. Any variation or replacement figured out by a person skilled in the art within the technical scope disclosed in this disclosure shall fall within the protection scope of this application. Therefore, the protection scope of this application shall be subject to the protection scope of the claims.

## Claims

1. An integrated circuit, wherein the integrated circuit comprises:
a substrate, having a first surface and a second surface that face away from each other;
a plurality of fins, located on the first surface, wherein the plurality of fins extend in a first direction and are spaced apart in a second direction, both the first direction and the second direction are parallel to the first surface, and the first direction intersects with the second direction;
a gate line, disposed across the plurality of fins, wherein the gate line extends in the second direction;
a source and a drain, located on the fin, wherein one of the source and the drain is a target electrode;
an isolation layer, located between two adjacent fins, wherein the isolation layer divides the gate line into a plurality of gate sub-lines;
a power contact structure, penetrating the substrate, wherein in a direction from the second surface to the first surface, the power contact structure comprises a first power contact portion and a second power contact portion located on the first power contact portion, the first power contact portion is connected to the second power contact portion, and the second power contact portion is electrically connected to the target electrode; and
a power distribution network, located on the second surface, wherein the power distribution network is electrically connected to the first power contact portion, wherein
the isolation layer is located on two opposite sides of the second power contact portion in the second direction.

2. The integrated circuit according to claim 1, wherein a connection surface between the first power contact portion and the second power contact portion is located within the first surface.

3. The integrated circuit according to claim 1 or 2, wherein a surface on a side that is of the first power contact portion and that is close to the second power contact portion is a third surface, and a surface on a side that is of the second power contact portion and that is close to the first power contact portion is a fourth surface; and
an orthogonal projection of the fourth surface on the first surface is located within a range of an orthogonal projection of the third surface on the first surface.

4. The integrated circuit according to any one of claims 1 to 3, wherein the integrated circuit further comprises a gate cut structure spaced apart from the isolation layer, and the gate cut structure is located between two adjacent gate sub-lines, and is located between two adjacent fins; and
the gate cut structure and the isolation layer are made of a same material, and are disposed on a same layer.

5. The integrated circuit according to claim 4, wherein in a direction perpendicular to the first surface, a height of the isolation layer is greater than a thickness of the gate cut structure.

6. The integrated circuit according to any one of claims 1 to 5, wherein the integrated circuit further comprises:
an epitaxial contact structure, located on the second power contact portion and the target electrode, and in contact with the second power contact portion and the target electrode.

7. The integrated circuit according to any one of claims 1 to 6, wherein the integrated circuit further comprises a first dielectric layer;
the first dielectric layer is located between the second surface and the power distribution network, and is located between the first power contact portion and the substrate; and
a surface on a side that is of the first power contact portion and that is away from the second power contact portion is flush with a surface on a side that is of the first dielectric layer and that is away from the second surface.

8. A preparation method for an integrated circuit, wherein the preparation method comprises:
forming an initial integrated circuit, wherein the initial integrated circuit comprises a substrate, a plurality of fins, a second dielectric layer, and a sacrificial layer; the substrate has a first surface and a second surface that face away from each other; the plurality of fins are located on the first surface, extend in a first direction, and are spaced apart in a second direction; the second dielectric layer is filled between two adjacent fins and covers the fins; the sacrificial layer is located on the second dielectric layer, the sacrificial layer comprises a sacrificial gate disposed across the plurality of fins, and the sacrificial gate extends in the second direction; and both the first direction and the second direction are parallel to the first surface, and the first direction intersects with the second direction;
forming a first gate cut trench on the sacrificial layer, wherein the first gate cut trench is located between two adjacent fins, and breaks the sacrificial gate;
forming an isolation layer, wherein the isolation layer covers at least a side wall of the first gate cut trench;
forming a second power contact portion in the first gate cut trench;
forming a first power contact portion on a side that is of the second power contact portion and that is close to the second surface, wherein the first power contact portion is connected to the second power contact portion; and
forming a power distribution network on the second surface, wherein the power distribution network is electrically connected to the first power contact portion.

9. The preparation method according to claim 8, wherein in a process of forming the first gate cut trench on the sacrificial layer, a second gate cut trench is further formed, the second gate cut trench is located between two adjacent fins, and breaks the sacrificial gate, and in a direction perpendicular to the first surface, a depth of the second gate cut trench is less than a depth of the first gate cut trench; and
in a process of forming the isolation layer, a gate cut structure is further formed, and the gate cut structure is located in the second gate cut trench.

10. The preparation method according to claim 8 or 9, wherein forming the first power contact portion on the side that is of the second power contact portion and that is close to the second surface comprises:
etching the substrate from a side on which the second surface is located to form a contact trench, wherein the contact trench exposes a surface on the side that is of the second power contact portion and that is close to the second surface; and
forming the first power contact portion in the contact trench.

11. The preparation method according to claim 10, wherein the isolation layer further covers a bottom wall of the first gate cut trench; and
before forming the first power contact portion in the contact trench, the preparation method further comprises:
removing, through the contact trench, a part that is of the isolation layer and that covers the bottom wall of the first gate cut trench, to expose the surface on the side that is of the second power contact portion and that is close to the second surface.

12. The preparation method according to any one of claims 8 to 11, wherein before forming the power distribution network on the second surface, the preparation method further comprises:
removing the sacrificial gate to form a gate line trench; and
filling the gate line trench with a conductive material to form a gate line.

13. An electronic device, wherein the electronic device comprises:
a circuit board; and
the integrated circuit according to any one of claims 1 to 7, wherein the integrated circuit is connected to the circuit board.
